# EUROPÄISCHE PATENTSCHRIFT

(11) **EP 2 852 822 B1**
(45) Veröffentlichungstag und Bekanntmachung des Hinweises auf die Patenterteilung: **26.09.2018**
(21) Anmeldenummer: 13726445.3
(22) Anmeldetag: 16.05.2013
(51) Int. Cl.: G01M 13/04, G01L 1/22

(54) **DEHNMESSSTREIFENANORDNUNG**
STRAIN GAUGE ARRANGEMENT
ENSEMBLE JAUGE DE DÉFORMATION

(30) Priorität: 22.05.2012 DE 102012208492
(43) Veröffentlichungstag der Anmeldung: 01.04.2015
(73) Patentinhaber: Schaeffler Technologies AG & Co. KG, 91074 Herzogenaurach (DE)
(72) Erfinder: GIERL, Jürgen, 91052 Erlangen (DE); HEIM, Jens, 97493 Bergrheinfeld (DE); SCHILLINGER, Jakob, 85080 Gaimersheim (DE)
(86) Internationale Anmeldenummer: PCT/EP2013/060114
(87) Internationale Veröffentlichungsnummer: WO 2013/174706

(56) Entgegenhaltungen:
- WO-A2-2009/148861
- GB-A- 2 457 096
- US-A1- 2002 001 981
- US-A1- 2005 163 461

## Beschreibung

### Gebiet der Erfindung

Die Erfindung betrifft ein Verfahren zur Herstellung einer Dehnmessstreifenanordnung an der Oberfläche eines Maschinenelements, sowie ein Maschinenelement mit einer Dehnmessstreifenanordnung, welche nach einem solchen Verfahren hergestellt worden ist.

### Hintergrund der Erfindung

Zur Ermittlung der Beanspruchung eines Maschinenelements wird regelmäßig die Verformung des Bauteils gemessen. Dabei wird üblicherweise eine Dehnmessstreifenanordnung eingesetzt, welche die Verformung an der Oberfläche des Maschinenelements erfasst.

Die Dehnmessstreifenanordnung kann hierbei gewöhnlich eine positive Dehnung (Streckung), sowie eine negative Dehnung (Stauchung) erfassen. Dazu wird die Dehnmessstreifenanordnung an eine zu messende Stelle der Oberfläche des Maschinenelements in der Regel stoffschlüssig aufgebracht. Bei einer Verformung des Maschinenelements an dieser Stelle wird die Dehnmessstreifenanordnung ebenfalls entsprechend verformt. Durch diese Verformung ändert sich ein Parameter der Dehnmessstreifenanordnung, wie beispielsweise der elektrische Widerstand. Dieser Parameter wird zur Messung erfasst. Die Dehnmessstreifenanordnung besteht regelmäßig insbesondere aus einem metallischen oder keramischen Material oder aus einem Halbleitermaterial.

Bei einer typischen Dehnmessstreifenanordnung wird eine Metallfolie auf einen Kunststoffträger aufgebracht und mit elektrischen Anschlüssen versehen. Damit ein ausreichend hoher Widerstand erreicht wird, ist die Leiterbahn mäanderförmig ausgeätzt. Eine zweite Kunststofffolie wird auf der Oberseite fest mit dem Kunststoffträger verklebt um das Widerstandsmaterial gegen Beeinträchtigungen von außen zu schützen.

Eine Dehnmessstreifenanordnung kann üblicherweise auch in Dünnschichttechnik, beispielsweise durch Aufdampfen oder Sputtern direkt an die zu messende Oberfläche des Maschinenelements aufgebracht werden. Dabei wird insbesondere eine Messschicht vollflächig aufgebracht und durch eine Lasermaterialbearbeitung oder durch ein photolithographisches Verfahren entsprechend strukturiert. Auf diese Messschicht wird üblicherweise noch vollflächig eine Schutzschicht aufgebracht, welche die Messschicht gegen äußere Einflüsse schützt.

Problematisch hierbei ist jedoch, dass durch die vollflächig aufgetragene Schutzschicht auch Kontaktstellen der Messschicht mit dieser Schutzschicht bedekt werden. Die vollflächige Beschichtung verhindert das Kontaktieren der Kontaktstellen der Messschicht mit einer entsprechenden Auswerteeinheit zur Erfassung und Auswertung der Parameteränderung, wie beispielsweise der Widerstandsänderung, und wird üblicherweise durch eine photolithographische Vorgehensweise mit aufwendigem Maskenverfahren und Ätztechnik teilweise entfernt.

Die Stand der Technik wird offenbart in DE69713433, GB2457069 und US2002/001981.

### Aufgabe der Erfindung

Es ist eine erste Aufgabe der Erfindung, ein Verfahren zur Herstellung einer Dehnmessstreifenanordnung an der Oberfläche eines Maschinenelements, insbesondere eines Lagerrings oder einer Welle, anzugeben, welches einfach und kostengünstig durchgeführt werden kann.

Eine zweite Aufgabe ist es, ein Maschinenelement, insbesondere einen Lagerring oder eine Welle, mit einer Dehnmessstreifenanordnung bereitzustellen, welches einfach und kostengünstig in der Fertigung ist.

### Lösung der Aufgabe

Die erste Aufgabe wird erfindungsgemäß gelöst durch die Merkmale des Anspruchs 1. Vorteilhafte Ausführungsformen und Weiterentwicklungen der Erfindung sind in den Unteransprüchen der nachfolgenden Beschreibung dargelegt.

In dem erfindungsgemäßen Verfahren zur Herstellung einer Dehnmessstreifenanordnung an der Oberfläche eines Maschinenelements, insbesondere eines Lagerrings oder einer Welle, werden an der Oberfläche eine verformungssensitive Messschicht und eine darüber liegende Schutzschicht aufgebracht. Die Schutzschicht wird mittels Laserbearbeitung lokal entfernt und die freigestellte Sensorschicht elektrisch kontaktiert.

Die Erfindung geht dabei von der Überlegung aus, dass ein Herstellungsverfahren auch dahingehend zu konzipieren ist, dass eine möglichst wirtschaftliche Fertigung realisierbar ist. Dies gilt umso mehr für den Bereich einer Serienfertigung, bei dem bereits eine Vereinfachung eines einzelnen Fertigungsschritts insgesamt eine große Zeit- und Kostenersparnis zur Folge haben kann. Die Erfindung geht weiter von der Überlegung aus, dass es bei der Herstellung einer Dehnmessstreifenanordnung an der Oberfläche eines Maschinenelements, insbesondere an nicht ebenen Oberflächen, wirtschaftlicher ist, zunächst die Schutzschicht vollflächig auf die Messschicht aufzutragen und sie erst anschließend gezielt lokal zu entfernen. Daher sieht die Erfindung vor, die Schutzschicht zunächst vollflächig aufzutragen und sie erst in einem nachgeordneten Fertigungsschritt mittels einer präzisen und einfachen Laserbearbeitung an den erforderlichen Bereichen lokal zu entfernen. Dadurch erlaubt die Erfindung eine automatisierte und wirtschaftliche Fertigungskette.

Bei dem Maschinenelement kann es sich insbesondere um die Welle oder den Lagerring eines Wälzlagers handeln. Hierbei kommt eine Standardbauform, wie beispielsweise ein Pendelkugellager, Schrägkugellager, Zylinderrollenlager oder Kegelrollenlager, sowie eine Sonderbauform, wie beispielsweise ein Radlager, in Betracht. Dabei kann der Lagerring, sowohl ein einteilig oder geteilt ausgeführter Außenring als auch ein einteilig oder geteilt ausgeführter Innenring eines entsprechenden Wälzlagers sein. Die Welle kann sowohl eine Hohlwelle als auch eine Vollwelle sein.

Die Dehnmessstreifenanordnung kann grundsätzlich an jeder Stelle der Oberfläche des Maschinenelements angebracht werden. Bei einem Lagerring kann die Dehnmessstreifenanordnung an einer Stelle der radial äußeren Mantelfläche, sowie an einem stirnseitigen Oberflächenebereich aufgebracht werden. Entsprechendes gilt für das Aufbringen an einer Welle. Dabei kann nur eine Dehnmessstreifenanordnung an eine entsprechende Stelle des Maschinenelements angebracht werden. Es ist aber auch möglich, mehrere Dehnmessstreifenanordnungen an der Oberfläche des Maschinenelements aufzubringen, wobei diese insbesondere an verschiedenen Stellen der Oberfläche aufgebracht werden können.

Die verformungssensitive Messschicht besteht insbesondere aus einem metallischen Material oder einem Halbleitermaterial. Insbesondere kann die Messschicht aus einer Nickel-Legierung oder aus Titanoxinitrid bestehen. Die Messschicht weist mindestens eine Kontaktstelle auf, die zum elektrischen Kontaktieren der Messschicht beispielsweise mit einer entsprechenden Auswerteeinheit zur Erfassung und Auswertung der Widerstandänderung dient.

Im Betrieb verformt sich die Messschicht entsprechend einer Verformung des Maschinenelements, das heißt, eine Verformung des Maschinenelements wird auf die Messschicht "übertragen". Die Messschicht wird dabei, je nach Verformung, positiv (Streckung) oder negativ (Stauchung) gedehnt. Durch die Verformung der Messschicht wird ihr elektrischer Widerstand im Vergleich zu der nicht verformten Messschicht verändert. Diese relative Widerstandsänderung ist insbesondere auf zwei Ursachen zurückzuführen: Zum einen auf die Änderung der Geometrie der Messschicht. Bei einer Dehnung ändern sich die Länge und die Querschnittsfläche der Messschicht. Dies ist insbesondere bei einer Messschicht aus einem metallischen Material besonders ausgeprägt und hier im Wesentlichen für die relative Widerstandsänderung verantwortlich. Zum anderen ist die relative Widerstandsänderung auf den piezoresistiven Effekt zurückzuführen. Dieser Effekt ist insbesondere bei einer Messschicht aus einem Halbleitermaterial sehr ausgeprägt, wohingegen hier der Einfluss der Geometrieänderung im Wesentlichen vernachlässigbar ist. Dabei verändert sich durch die Verformung des Kristallgitters und damit der Bandstruktur die Anzahl der Elektronen im Leitungsband und somit die Leitfähigkeit des Materials. Durch den bei Halbleitern sehr stark ausgeprägten piezoresistiven Effekt ist die Dehnempfindlichkeit von Halbleitern insgesamt größer als die von Metallen.

Die Schutzschicht dient im Wesentlichen dem Schutz der Messschicht vor Verunreinigungen, Korrosion und mechanischer Beschädigung, sowie vor ungewollten Kontakt der Messschicht mit leitfähigen Materialien.

Bei der Anbringung der Dehnmessstreifenanordnung an die Oberfläche eines Materialelements werden zunächst die Messschicht und darüber die Schutzschicht, jeweils insbesondere mit einer Dicke im Nano- bis Mikrometerbereich, aufgebracht. In einem weiteren Fertigungsschritt wird die Schutzschicht durch eine Laserbearbeitung lokal entfernt. Hierbei wird die Schutzschicht insbesondere im Bereich der mindestens einen Kontaktstelle entfernt. Die Entfernung durch Laserbearbeitung wird beispielsweise mittels Laserablation durchgeführt. Die hierbei Verwendung findende Laserstrahlung führt zur Erhitzung und zum Verdampfen des Materials. Die unter der zu entfernenden Schutzschicht liegende Messschicht wird durch die Laserbearbeitung nicht beeinträchtigt. Die Messschicht wird danach über die derart freigestellte mindestens eine Kontaktstelle elektrisch kontaktiert.

Das dargestellte Verfahren hat den Vorteil eines einfachen und kostengünstigen Herstellungsverfahrens für eine Dehnmessstreifenanordnung an der Oberfläche eines Maschinenelements. Die erst nachträgliche lokale Entfernung der Schutzschicht ermöglicht es, die Schutzschicht zunächst vollflächig über die Messschicht aufzubringen. Beim Aufbringen der Schutzschicht müssen also keine speziellen und teilweise sehr aufwendigen und kostenintensiven Verfahren oder Vorrichtungen vorgehen werden, welche eine nur partielle Aufbringung einer Schutzbeschichtung auf die Messschicht ermöglichen. Die vollflächige Schutzbeschichtung reduziert zudem die Wahrscheinlichkeit, dass die mindestens eine Kontaktstelle vor der elektrischen Kontaktierung mit Verunreinigungen belegt ist, da die Kontaktstelle erst vor der Kontaktierung freigestellt wird. Die lokale Entfernung der Schutzschicht mittels Laserbearbeitung ermöglicht darüber hinaus eine einfache und exakte Freistellung der mindestens einen Kontaktstelle, ohne hierbei die Messschicht oder die umliegende Schutzschicht zu beeinträchtigen. Ferner lässt sich eine derartige Laserbearbeitung in eine automatisierte Fertigungskette integrieren.

In zweckmäßiger Durchführung des Verfahrens wird zwischen der Oberfläche des Maschinenelements und der Messschicht eine Isolationsschicht aufgebracht. Bevorzugt wird dabei zunächst die Isolationsschicht, insbesondere mit einer Dicke im Nano- bis Mikrometerbereich, an der Oberfläche des Maschinenelements aufgebracht, und anschließend über die Isolationsschicht die Messschicht sowie die Schutzschicht. Die Isolationsschicht dient insbesondere zur elektrischen Isolation der Messschicht gegenüber einer leitfähigen Oberfläche des Maschinenelements. Daneben kann sie auch zum Schutz der Messschicht dienen. Die Isolationsschicht besteht beispielsweise aus Aluminiumoxid, Siliziumoxid, Siliziumnitrid oder einer Kombination dieser Materialien.

Die Messschicht wird zweckmäßigerweise vor dem Aufbringen der Schutzschicht strukturiert. Dabei ist die Art der Strukturierung insbesondere an die jeweiligen Anforderungen angepasst und beispielsweise von dem Material der Messschicht, der erwarteten Art und Stärke der Verformung des Maschinenelements, sowie dem Platzangebot der zu messenden Stelle an der Oberfläche des Maschinenelements abhängig. Insbesondere wird die Messschicht mäanderförmig strukturiert. Dadurch kann ein ausreichend hoher Widerstand und somit eine hohe Empfindlichkeit bei möglichst geringem Platzbedarf erreicht werden.

Die Strukturierung der Messschicht wird beispielsweise durch ein photolithographisches Verfahren erzeugt. Im Wesentlichen wird dabei insbesondere mittels Belichtung das Bild einer Photomaske auf einen lichtempfindlichen Photolack übertragen. Anschließend werden die belichteten Stellen des Photolacks aufgelöst (alternativ ist auch die Auflösung der unbelichteten Stellen möglich, wenn der Photolack unter Licht aushärtet). So entsteht eine lithographische Maske entsprechend der gewünschten Struktur, welche die weitere Bearbeitung durch chemische und physikalische Verfahren ermöglicht, etwa das Aufbringen Messschicht in die offenen Fenster oder das teilweise Ätzen der Messschicht unter den offenen Fenstern. Bevorzugt wird die Strukturierung aber durch ein Laserverfahren erzeugt. Hierbei wird die Struktur nach dem vollflächigen Aufbringen der Messschicht, insbesondere mittels Laserablation herausgearbeitet. Nach der Strukturierung der Messschicht wird über diese die Schutzschicht vollflächig aufgebracht.

Alternativ werden die Strukturierung der Messschicht und die Entfernung der Schutzschicht in einem Arbeitsgang durchgeführt. Dabei werden insbesondere über eine Laserbearbeitung mit zwei Lasereinstellungen sowohl die Struktur der Messschicht erzeugt, als auch die mindestens eine Kontaktstelle der Messschicht von der Schutzschicht freigelegt. Auf diese Weise wird der Fertigungsprozess zeitlich weiter optimiert. Ein Laserstrahl mit einer ersten Lasereinstellung dient hierbei der Strukturierung der Messschicht, wobei er sowohl Schutzschicht als auch Messschicht entfernt. Ein Laserstahl mit einer zweiten Lasereinstellung dient nur zur lokalen Entfernung der Schutzschicht. Dabei können die Laserstrahlen mittels eines Lasers und zeitlich aufeinanderfolgend erzeugt werden. Es ist aber auch möglich, dass die Laserstrahlen (teilweise) zeitgleich mittels mehrerer Laser erzeugt werden.

In einer vorteilhaften Durchführung des Verfahrens wird die Schutzschicht durch eine Gasphasenabscheidung, bevorzugt durch eine PVD- oder PACVD-Abscheidung aufgebracht. Grundsätzlich kommt sowohl eine physikalische Gasphasenabscheidung (Physical Vapour Deposition, kurz: PVD), als auch eine chemische Gasphasenabscheidung (Chemical Vapour Deposition, kurz: CVD) in Betracht. Insbesondere kann bei einem PVD-Verfahren ein geeigneter Stoff unter Anwesenheit oder Zuführung eines entsprechenden reaktiven Gases in den gasförmigen Zustand überführt werden. Auf dem Maschinenelement schlägt sich dann im Wesentlichen eine chemische Verbindung von aus dem eingebrachten Stoff und aus dem reaktiven Gas stammenden Elementen nieder. Insbesondere umströmt bei einem CVD-Verfahren innerhalb eines Reaktionsraumes ein Gasgemisch, das entsprechende Reaktanten enthält, die zu beschichtende Messschicht des Maschinenelements. Die Moleküle werden durch Energiezufuhr dissoziert und die Radikale einer Reaktion zugeführt, wodurch eine Feststoffkomponente, welche die Schutzschicht bildet, abgeschieden wird. Bevorzugt wird die chemische Reaktion hierbei durch ein Plasma aktiviert (Plasma-Enhanced Chemical Vapour Deposition, kurz: PECVD; oder auch Plasma-Assisted Chemical Vapour Deposition, kurz: PACVD).

Als Schutzschicht wird vorzugsweise eine Schicht aus wasserstoffhaltigem, amorphen Kohlenstoff, Siliziumoxid, Siliziumnitrid und/oder Aluminiumoxid aufgebracht. Die Schutzschicht kann demnach sowohl nur wasserstoffhaltigen, amorphen Kohlenstoff, Siliziumoxid, Siliziumnitrid oder Aluminiumoxid, als auch eine Kombination davon umfassen. Amorpher Kohlenstoff ist auch bekannt unter der Bezeichnung DLC (Diamond-Like Carbon). Hierbei wird mindestens eine Lage als eine wasserstoffhaltige, amorphe Kohlenstoffschicht (Nomenklatur: a-C:H) oder als eine modifizierte wasserstoffhaltige, amorphe Kohlenstoffschicht (Nomenklatur: a-C:H:X) aufgebracht. Bei einer modifizierten wasserstoffhaltigen, amorphen Kohlenstoffschicht, werden ein oder mehrere Fremdelemente (X), wie beispielsweise Si, O, N, oder B, mit eingebracht. Eine Schutzschicht aus einem dieser Materialien oder aus einer Kombination derer zeichnet sich insbesondere durch einen hohen elektrischen Widerstand, insbesondere größer als 200 MOhm pro µm, eine hohe Härte und Zähigkeit aus. Insbesondere wird die Schutzschicht dabei in einer oder mehreren Lagen aufgebracht.

Vorteilhafterweise wird die Schutzschicht mit einer Dicke von weniger als 20 µm erzeugt. Eine Schutzschicht mit einer solchen Dicke bietet einen ausreichenden Schutz der Messschicht vor mechanischer Beschädigung.

Die freigelegte Messschicht wird vorteilhafterweise vor der Kontaktierung gereinigt, um eventuell vorhandene Oxide oder sonstige Verunreinigungen zu entfernen. Diese Reinigung kann insbesondere mittels einer Plasmareinigung oder durch Trockeneisstrahlen durchgeführt werden.

Nach der Kontaktierung werden die Messschicht und die Schutzschicht vorteilhafterweise versiegelt. Hierbei kann mit einem organischen oder anorganischen Material versiegelt werden. Auf diese Weise kann die nach der Laserbearbeitung und Kontaktierung unter Umständen noch teilweise freiliegende, das heißt nicht mehr mit einer Schutzschicht bedeckte Messschicht, mit einer schützenden Schicht belegt werden. Dabei wird auch die Schutzschicht mit versiegelt. Die Versiegelung dient insbesondere auch dazu, bei einer optional in einem Arbeitsgang durchgeführten Strukturierung der Messschicht und Entfernung der Schutzschicht, die durch die Strukturierung seitlich freigelegte Messschicht und teilweise freigelegte Isolationsschicht zu versiegeln.

Die zweite Aufgabe der Erfindung wird erfindungsgemäß gelöst durch die Merkmale des Anspruchs 10.

Das erfindungsgemäße Maschinenelement, insbesondere ein Lagerring oder eine Welle, umfasst demnach eine Dehnmessstreifenanordnung, welche nach dem vorbeschriebenen Verfahren hergestellt worden ist.

Das Maschinenelement ist insbesondere eine Welle oder ein Lagerring eines Wälzlagers. Dabei kommt eine Standardbauform, wie beispielsweise ein Pendelkugellager, Schrägkugellager, Zylinderrollenlager oder Kegelrollenlager, sowie eine Sonderbauform in Betracht. Der Lagerring kann sowohl ein einteilig oder geteilt ausgeführter Außenring als auch ein einteilig oder geteilt ausgeführter Innenring eines entsprechenden Wälzlagers sein. Die Welle kann sowohl eine Hohlwelle als auch eine Vollwelle sein.

Die Dehnmessstreifenanordnung kann grundsätzlich an jeder Stelle der Oberfläche des Maschinenelements angebracht sein. Bei einem Lagerring kann die Dehnmessstreifenanordnung an einer Stelle der radial äußeren Mantelfläche, sowie an einem stirnseitigen Oberflächenbereich aufgebracht sein. Entsprechendes gilt für eine Welle. Dabei kann nur eine Dehnmessstreifenanordnung an eine entsprechende Stelle des Maschinenelements angebracht sein. Es ist aber auch möglich, dass mehrere Dehnmessstreifenanordnungen an der Oberfläche des Maschinenelements aufgebracht sind, wobei diese insbesondere an verschiedenen Stellen der Oberfläche aufgebracht sein können.

Das angegebene Maschinenelement hat den Vorteil einer einfachen und kostengünstigen Herstellung. Durch die Herstellung der Dehnmessstreifenanordnung an der Oberfläche des Maschinenelements nach einem Verfahren der vorbeschriebenen Art kann das Maschinenelement auf einfache und kostengünstige Weise gefertigt werden.

### Kurze Beschreibung der Zeichnung

Ausführungsbeispiele der Erfindung werden im Folgenden anhand einer Zeichnung näher erläutert: Darin zeigen:
- Fig. 1: nach einem ersten Fertigungsschritt in schematischer Schnittdarstellung ein Maschinenelement mit einer Isolationsschicht, einer strukturierten Messschicht und einer Schutzschicht,
- Fig. 2: in einem zweiten Fertigungsschritt in schematischer Schnittdarstellung eine Laserbearbeitung zur lokalen Entfernung einer Schutzschicht,
- Fig. 3: nach einem zweiten Fertigungsschritt in schematischer Schnittdarstellung ein Maschinenelement mit lokal freigelegter Messschicht,
- Fig. 4: nach einem weiteren Fertigungsschritt in schematischer Schnittdarstellung ein Maschinenelement mit einer Dehnmessstreifenanordnung,
- Fig. 5: nach einem alternativen ersten Fertigungsschritt in schematischer Schnittdarstellung ein Maschinenelement mit einer Isolationsschicht, einer unstrukturierten Messschicht und einer Schutzschicht,
- Fig. 6: in einem alternativen zweiten Fertigungsschritt in schematischer Schnittdarstellung eine Laserbearbeitung zur lokalen Entfernung einer Schutzschicht und zur Strukturierung einer Messschicht, und
- Fig. 7: nach einem alternativen weiteren Fertigungsschritt in schematischer Schnittdarstellung ein Maschinenelement mit einer Dehnmessstreifenanordnung.

Einander entsprechende Teile sind in allen Figuren mit gleichen Bezugszeichen versehen.

### Ausführliche Beschreibung der Zeichnung

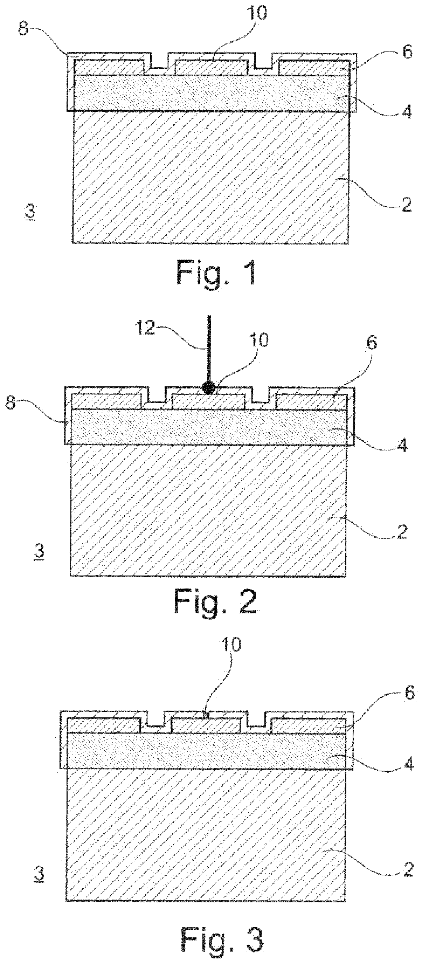

In Fig. 1 ist ein Maschinenelement 2 aus Stahl, welches einen Teil eines Lagerrings 3 zeigt, dargestellt, an dessen Oberfläche in einem ersten Fertigungsschritt eine Isolationsschicht 4, eine strukturierte Messschicht 6 und eine Schutzschicht 8 aufgebracht worden sind. Das Maschinenelement 2 zeigt einen Teil eines Lagerrings 9. Hierbei ist zunächst die Isolationsschicht 4 auf die Oberfläche des Maschinenelements 2 aufgebracht worden. Die Isolationsschicht besteht aus Aluminiumoxid und dient insbesondere zur elektrischen Isolation der Messschicht 6. Alternativ kann die Isolationsschicht 4 auch aus Siliziumoxid, Siliziumnitrid oder einer Kombination der genannten Materialien bestehen. Auf die Isolationsschicht 4 ist eine strukturierte Messschicht 6 aus einer Nickel-Legierung oder Titanoxinitrid aufgebracht worden, welche zur Erfassung einer Verformung des Maschinenelements durch entsprechende eigene Verformung und damit verbundener elektrischer Widerstandsänderung im Betrieb dient. Die Messschicht 6 weist eine Kontaktstelle 10 auf, welche zum elektrischen Kontaktieren der Messschicht 6 mit einer Auswerteeinheit dient. Auf die Messschicht 6 ist eine Schutzschicht 8 mittels PACVD-Verfahren (Plasma-Assisted Chemical Vapour Deposition) vollflächig aufgebracht worden. Alternativ kann die Schutzschicht 8 auch mittels eines PVD-Verfahrens (Physical Vapour Deposition) vollflächig aufgebracht worden sein. Die Schutzschicht 8 umfasst wasserstoffhaltigen, amorphen Kohlenstoff und bedeckt die Messschicht 6 seitlich und von oben, sowie die Isolationsschicht 4 seitlich. Alternativ kann die Schutzschicht 8 auch Siliziumoxid, Siliziumnitrid oder eine Kombination dieser Materialien umfassen. Die Schutzschicht 8 weist einen hohen elektrischen Widerstand, der größer als 200 MOhm pro µm ist, eine hohe Härte und Zähigkeit, sowie einen geringen Gleitreibungskoeffizienten auf und dient im Wesentlichen zum Schutz vor Verunreinigungen, Korrosion und mechanischer Beschädigung, sowie vor ungewollten Kontakt der Messschicht 6 mit leitfähigen Materialien.

Fig. 2 zeigt in einem zweiten Fertigungsschritt eine Laserbearbeitung zur lokalen Entfernung der Schutzschicht 8. Hierbei wird die Schutzschicht 8 im Bereich der Kontaktstelle 10 mittels Laserablation entfernt. Dabei wird die Schutzschicht 8 mit einer Laserstrahlung 12 abgetragen. Die hierbei Verwendung findende Laserstrahlung 12 führt zur Erhitzung und zum Verdampfen des Materials. Diese erst nachträgliche lokale Entfernung der Schutzschicht 8 ermöglicht es, die Schutzschicht 8 in dem vorgeordneten Fertigungsschritt zunächst vollflächig über die Messschicht 6 aufzubringen, wodurch keine speziellen und teilweise sehr aufwendigen Verfahren oder Vorrichtungen vorgehen werden müssen, welche eine nur partielle Aufbringung einer Schutzbeschichtung auf die Messschicht 6 ermöglichen. Die lokale Entfernung der Schutzschicht 8 mittels Laserbearbeitung ermöglicht darüber hinaus eine einfache und exakte Freistellung der Kontaktstelle 10, ohne hierbei die Messschicht 6 oder die umliegende Schutzschicht 8 zu beeinträchtigen.

In Fig. 3 ist nach einem zweiten Fertigungsschritt ein Maschinenelement 2 mit lokal freigelegter Messschicht 6 gezeigt. Hierbei weist die Messschicht 6 im Bereich einer Kontaktstelle 10 keine Schutzschicht 8 auf.

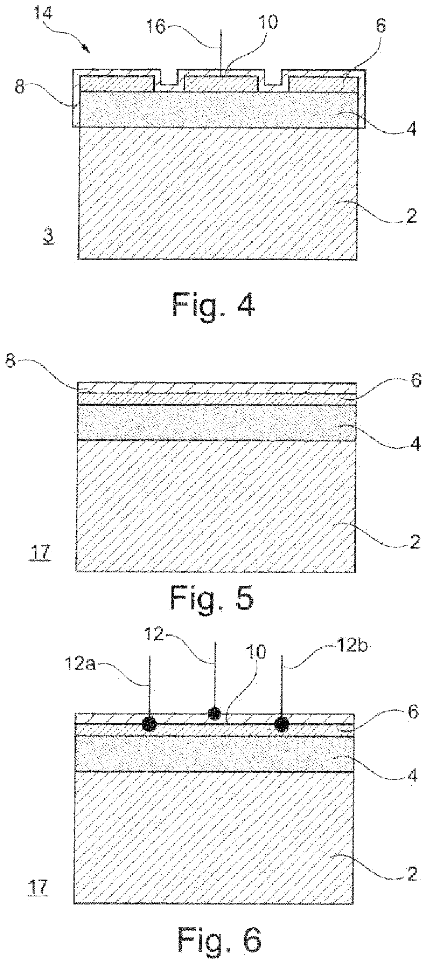

Fig. 4 zeigt nach einem weiteren Fertigungsschritt, in dem die Messschicht 6 elektrisch kontaktiert worden ist, ein Maschinenelement 2 mit einer Dehnmessstreifenanordnung 14. Die Dehnmessstreifenanordnung 14 umfasst eine Isolationsschicht 4, eine strukturiere Messschicht 6 und eine Schutzschicht 8. An eine Kontaktstelle 10 der Messschicht 6 ist eine elektrische Leitung 16 angebracht. Bei einer Verformung des Maschinenelements 2 wird die Dehnmessstreifenanordnung 14 und insbesondere die Messschicht 6 ebenfalls entsprechend verformt. Durch diese Verformung verändert sich der elektrische Widerstand der Messschicht 6. Zur Erfassung und Auswertung der Widerstandänderung der Messschicht 6 kann diese über die elektrische Leitung 16 beispielsweise mit einer entsprechenden Auswerteeinheit (nicht dargestellt) verbunden werden.

In Fig. 5 ist ein Maschinenelement aus Stahl 2, welches einen Teil einer Welle 17 zeigt, dargestellt, an dessen Oberfläche in einem alternativen ersten Fertigungsschritt eine Isolationsschicht 4, eine unstrukturierte Messschicht 6 und eine Schutzschicht 8 aufgebracht worden sind. Die Messschicht 6 liegt hierbei unstrukturiert, das heißt vollflächig zwischen Isolationsschicht 4 und Schutzschicht 8 vor. Die Schutzschicht 8 bedeckt die Messschicht 6 nur von oben. Ansonsten entspricht dieses Maschinenelement 2 im Wesentlichen dem in Fig. 1 dargestelltem Maschinenelement 2.

In einem alternativen zweiten Fertigungsschritt ist in Fig. 6 eine Laserbearbeitung zur lokalen Entfernung einer Schutzschicht 8 und zur Strukturierung einer Messschicht 6 gezeigt. Dabei werden über die Laserbearbeitung mit zwei Lasereinstellungen sowohl die Struktur der Messschicht 6 erzeugt, als auch eine Kontaktstelle 10 der Messschicht 6 von der Schutzschicht 8 freigelegt. Auf diese Weise wird der Fertigungsprozess zeitlich weiter optimiert. Die dargestellten Laserstrahlen 12a, 12b mit einer ersten Lasereinstellung dienen hierbei der Strukturierung der Messschicht 6, wobei sie sowohl Schutzschicht 8, als auch Messschicht 6 entfernen. Der Laserstahl 12 mit einer zweiten Lasereinstellung dient nur der Entfernung der Schutzschicht 8 im Bereich der Kontaktstelle 10. Dabei können die Laserstrahlen 12, 12a, 12b mittels eines Lasers und zeitlich aufeinanderfolgend erzeugt werden. Es ist aber auch möglich, dass die Laserstrahlen 12, 12a, 12b zeitglich mittels mehrere Laser erzeugt werden.

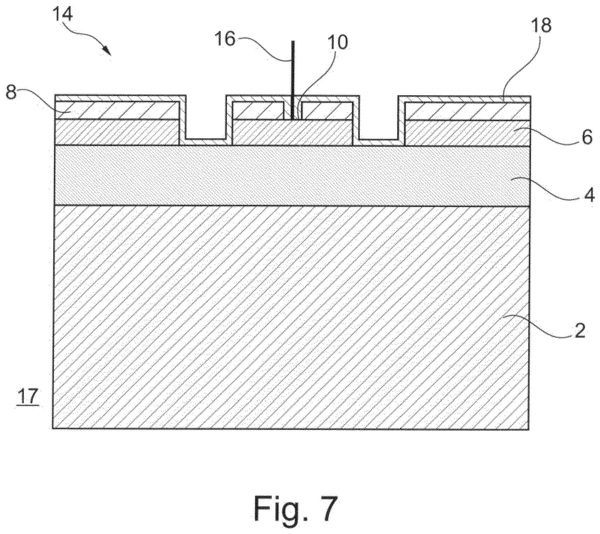

Fig. 7 zeigt nach einem alternativen weiteren Fertigungsschritt, in dem die Messschicht 6 elektrisch kontaktiert und versiegelt worden ist, ein Maschinenelement 2 mit einer Dehnmessstreifenanordnung 14. Die Dehnmessstreifenanordnung 14 umfasst eine Isolationsschicht 4, eine strukturiere Messschicht 6 und eine Schutzschicht 8. An eine Kontaktstelle 10 der Messschicht 6 ist eine elektrische Leitung 16 angebracht. Nach dem Anbringen der elektrischen Leitung 16 ist die Messschicht 6 mit einer Versiegelungsschicht 18 versehen worden. Auf diese Weise ist die nach der Laserbearbeitung und Kontaktierung noch teilweise freiliegende, das heißt nicht mehr mit einer Schutzschicht 8 bedeckte Messschicht 6, mit einer schützenden Versiegelungsschicht 18 belegt worden. Dabei sind auch die noch vorhandene Schutzschicht 8 und die infolge der Strukturierung teilweise freigelegte Isolationsschicht 4 mit versiegelt worden.

### Liste der Bezugszahlen

- 2: Maschinenelement
- 3: Lagerring
- 4: Isolationsschicht
- 6: Messschicht
- 8: Schutzschicht
- 10: Kontaktstelle
- 12, 12a, 12b: Laserstrahl
- 14: Dehnmessstreifenanordnung
- 16: elektrische Leitung
- 17: Welle
- 18: Versiegelungsschicht

## Patentansprüche

1. Verfahren zur Herstellung einer Dehnmessstreifenanordnung (14) an der Oberfläche eines Maschinenelements (2), insbesondere eines Lagerrings (3) oder einer Welle (17), wobei an der Oberfläche eine verformungssensitive Messschicht (6) und eine darüber liegende Schutzschicht (8) aufgebracht werden, wobei die Schutzschicht (8) lokal mittels Laserbearbeitung entfernt wird, und wobei die dadurch freigelegte Messschicht (6) elektrisch kontaktiert wird,

2. Verfahren nach Anspruch 1, wobei zwischen der Oberfläche des Maschinenelements (2) und der Messschicht (6) eine Isolationsschicht (4) aufgebracht wird.

3. Verfahren nach Anspruch 1 oder 2, wobei die Messschicht (6) vor dem Aufbringen der Schutzschicht (8) strukturiert wird.

4. Verfahren nach Anspruch 1 oder 2, wobei die Messschicht (6) strukturiert wird, und wobei die Strukturierung und die Entfernung der Schutzschicht (8) in einem Arbeitsgang durchgeführt werden,

5. Verfahren nach einem der vorhergehenden Ansprüche, wobei die Schutzschicht (8) durch eine PVD- oder PACVD-Abscheidung aufgebracht wird.

6. Verfahren nach einem der vorhergehenden Ansprüche, wobei als Schutzschicht (8) eine Schicht aus wasserstoffhaltigem, amorphen Kohlenstoff, Siliziumoxid, Siliziumnitrid und/oder Aluminiumoxid aufgebracht wird.

7. Verfahren nach einem der vorhergehenden Ansprüche, wobei die Schutzschicht (8) mit einer Dicke von weniger als 20 µm erzeugt wird.

8. Verfahren nach einem der vorhergehenden Ansprüche, wobei die freigelegte Messschicht (6) vor der Kontaktierung gereinigt wird.

9. Verfahren nach einem der vorhergehenden Ansprüche, wobei die Messschicht (6) und die Schutzschicht (8) nach der Kontaktierung versiegelt werden.

10. Maschinenelement (2), insbesondere ein Lagerring (3) oder eine Welle (17), mit einer Dehnmessstreifenanordnung (14), hergestellt nach einem der vorhergehenden Ansprüche.

## Claims

1. Method for producing a strain gauge arrangement (14) on the surface of a machine element (2), in particular of a bearing ring (3) or of a shaft (17), wherein a deformation-sensitive measurement layer (6) and a protective layer (8) located thereabove are applied to the surface, wherein the protective layer (8) is removed locally by means of laser machining and wherein the measurement layer (6) exposed as a result thereof is electrically contacted.

2. Method according to Claim 1, wherein an insulation layer (4) is applied between the surface of the machine element (2) and the measurement layer (6).

3. Method according to Claim 1 or 2, wherein the measurement layer (6) is structured before the application of the protective layer (8).

4. Method according to Claim 1 or 2, wherein the measurement layer (6) is structured and wherein the structuring and the removal of the protective layer (8) are performed in one operation.

5. Method according to one of the preceding claims, wherein the protective layer (8) is applied by PVD or PACVD deposition.

6. Method according to one of the preceding claims, wherein a layer composed of hydrogen-containing, amorphous carbon, silicon oxide, silicon nitride and/or aluminium oxide is applied as the protective layer (8).

7. Method according to one of the preceding claims, wherein the protective layer (8) is generated with a thickness of less than 20 µm.

8. Method according to one of the preceding claims, wherein the exposed measurement layer (6) is cleaned before the contacting.

9. Method according to one of the preceding claims, wherein the measurement layer (6) and the protective layer (8) are sealed after the contacting.

10. Machine element (2), in particular a bearing ring (3) or a shaft (17), having a strain gauge arrangement (14), produced according to one of the preceding claims.

## Revendications

1. Procédé de fabrication d'un arrangement de jauge d'allongement (14) sur la surface d'un élément de machine (2), notamment une bague de palier (3) ou un arbre (17), une couche de mesure (6) sensible à la déformation et une couche de protection (8) au-dessus de celle-ci étant appliquées sur la surface, la couche de protection (8) étant enlevée localement par usinage au laser, et un contact électrique étant établi avec la couche de mesure (6) ainsi libérée.

2. Procédé selon la revendication 1, une couche d'isolation (4) étant appliquée entre la surface de l'élément de machine (2) et la couche de mesure (6).

3. Procédé selon la revendication 1 ou 2, la couche de mesure (6) étant structurée avant l'application de la couche de protection (8).

4. Procédé selon la revendication 1 ou 2, la couche de mesure (6) étant structurée et la structuration et l'enlèvement de la couche de protection (8) étant effectués en une seule opération.

5. Procédé selon l'une des revendications précédentes, la couche de protection (8) étant appliquée par un dépôt physique en phase vapeur ou un dépôt chimique en phase vapeur assisté par plasma.

6. Procédé selon l'une des revendications précédentes, la couche de protection (8) appliquée étant une couche en carbone amorphe contenant de l'hydrogène, en oxyde de silicium, en nitrure de silicium et/ou en oxyde d'aluminium.

7. Procédé selon l'une des revendications précédentes, la couche de protection (8) étant produite avec une épaisseur inférieure à 20 µm.

8. Procédé selon l'une des revendications précédentes, la couche de mesure (6) libérée étant nettoyée avant l'établissement du contact.

9. Procédé selon l'une des revendications précédentes, la couche de mesure (6) et la couche de protection (8) étant scellées après l'établissement du contact.

10. Élément de machine (2), notamment une bague de palier (3) ou un arbre (17), comprenant un arrangement de jauge d'allongement (14) fabriqué selon l'une des revendications précédentes.
